# EUROPEAN PATENT APPLICATION

(11) **EP 1 255 291 A2**
(43) Date of publication of application: **06.11.2002**
(21) Application number: 02076457.7
(22) Date of filing: 15.04.2002
(51) Int. Cl.: H01L 21/38, H01L 33/00

(54) **Forming low resistivity P-type gallium nitride**

(30) Priority: 30.04.2001 US 846980
(71) Applicant: LumiLeds Lighting U.S., LLC, San Jose, CA 95131-1008 (US)
(72) Inventor: Stockman, Stephen A., Prof. Holstlaan 6, 5656 AA Eindhoven (NL); Rudaz, Serge L., Prof. Holstlaan 6, 5656 AA Eindhoven (NL); Misra, Mira S., Prof. Holstlaan 6, 5656 AA Eindhoven (NL)
(74) Representative: Dusseldorp, Jan Charles

(57) **Abstract**

One embodiment of a process that forms low resistivity III-V nitride (e.g., GaN) p-type layers removes all sources of hydrogen (typically NH₃) in the epitaxial growth chamber during the post growth cool-down process. By eliminating sources of hydrogen during the cool-down process, any additional passivation of the acceptor impurities (e.g., Mg) by hydrogen atoms during cool-down is avoided. After the cool-down process, the wafer is annealed at a relatively low temperature (e.g., below 625°C) to remove nearly all of the hydrogen from the Mg-doped layers. The anneal can take place at a low temperature since the diffusivity of H in the p-type GaN layers is much higher than in i-type GaN layers. If the p-type layers are used in an LED, since the low temperature anneal does not degrade the GaN layers' crystallinity, the intensity of the LED's emitted light is not decreased by the anneal process. In other embodiments, the Mg-doped GaN layers are capped with an n-type GaN layer or any n-type semiconductor layer during epitaxial growth, prior to cool-down, to block the in-diffusion of H during the cool-down period. The n-type cap is then removed prior to the low-temperature anneal step. In other embodiments, the Mg-doped GaN layers are made slightly p-type after the cool-down but prior to annealing. This may be done using various processes.

## Description

The present invention relates to light emitting diodes and, in particular, to lowering the resistivity of p-type gallium nitride layers in a light emitting diode.

Light emitting diodes ("LEDs") are a highly durable solid state source of light capable of achieving high brightness and having numerous applications including displays, indicators, printers, traffic signals, and general illumination among others. Direct bandgap semiconductors are arguably the most efficient means to generate light from electricity. One important class of light emitting devices is based upon compounds of Group III atoms (particularly In, Ga, Al) with nitrogen N, typically abbreviated as "III-Nitride." III Nitrides are a subset of a broader class of compound semiconductor known as III-V semiconductors. One family of III-Nitride compounds has the general composition InₓAl_{y}Ga_{1-x-y}N where 0≤(x+y)≤1. This general composition will be simply referred to as GaN. III-Nitrides are capable of emitting light that spans a large portion of the visible and near-visible electromagnetic spectrum including ultraviolet, blue, green and yellow wavelengths. Improving the brightness and other optical properties of LEDs without a substantial increase in cost is an important technological goal.

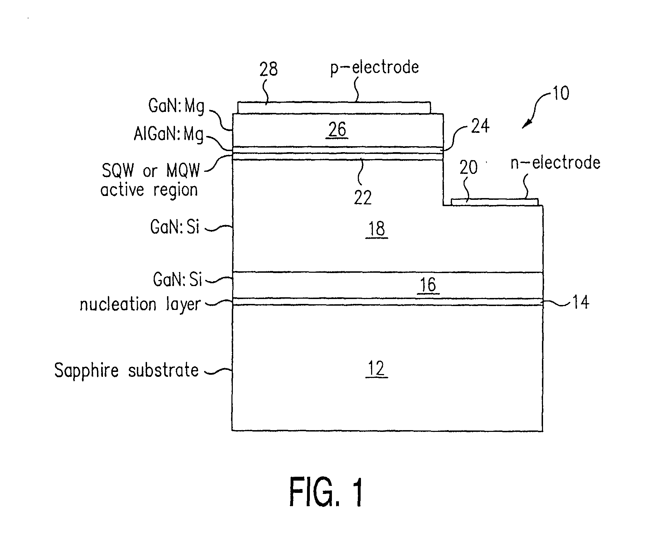

Fig. 1 is an example of one of many types of LED designs and serves to illustrate the general structure of an LED.

The LED 10 uses a transparent sapphire substrate 12. Over the substrate 12 is formed a nucleation layer 14 that acts as a buffer layer for the lattice mismatch between the crystalline structure of the substrate 12 and overlying layers.

A first n-type doped GaN layer 16 is formed over layer 14 using known techniques. Another n-type GaN layer 18 is formed over layer 16. An active layer 22 is formed over layer 18. The conductivity of the n-type GaN layer 18 is important since it must conduct current from the n-electrode 20 to the light emitting active layer 22. The active layer 22 may actually consist of several layers and may use a single quantum well (SQW) or a multi-quantum well (MQW) design.

Above the active layer 22 is formed a p-type AlGaN layer 24 (compounds containing indium are also used) that injects holes into the active layer 22, which combine with electrons injected into the active layer 22 from the n-type GaN layer 18. Layers 24 and 18 also act as confinement layers for the electrons and holes.

Another conductive p-type GaN layer 26 conducts current from a p-electrode 28 to layer 24. Increasing the hole concentration and lowering the resistivity of the p-type layers 24 and 26 improves the performance of the LED.

When LED 10 is forward biased, the recombination of holes and electrons in the active layer 22 results in emission of light of a wavelength determined by the structure and composition of the active layer 22. The various layers, including the substrate, are typically transparent, and light exits the LED 10 through the various sides of LED 10, depending upon the geometry and packaging of the particular LED. For example, the LED may be packaged with the contacts oriented downward in a flip-chip configuration.

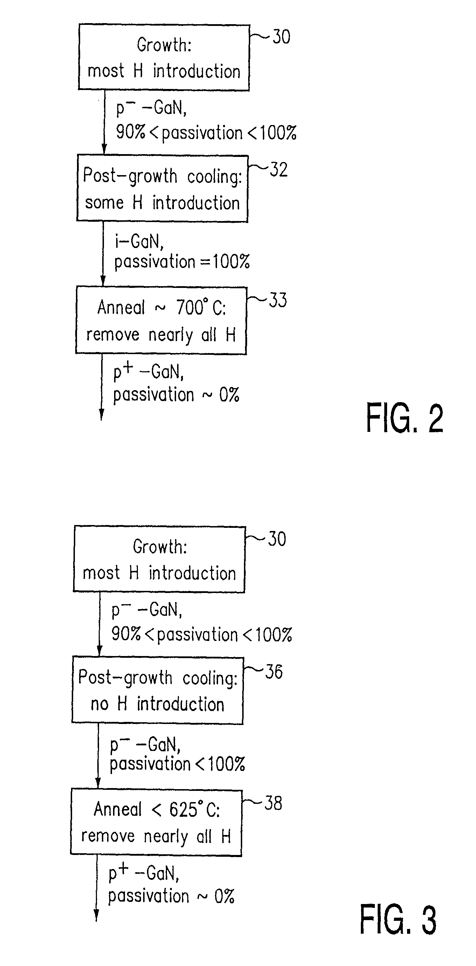

Although forming a low resistivity n-type GaN layer is relatively easy, forming a p-type GaN layer with low resistivity has proven difficult. In a typical process for forming the various GaN epitaxial layers, NH₃ (ammonia) gas is introduced into a chamber during a metalorganic chemical vapor deposition (MOCVD) process to contribute the N component, while other gases are introduced to contribute the Group III components and the p-type dopant, typically magnesium (Mg). During growth of the Mg-doped GaN material, some of the hydrogen atoms from the reaction gases are incorporated in the epitaxial layers and form a complex with the Mg dopants. This passivates the Mg acceptors, effectively neutralizing the effect of the Mg dopants as acceptors. This is illustrated in the flowchart of Fig. 2, which illustrates pertinent steps of a prior art process for forming a GaN LED. In step 30, the epitaxial layers are grown on a heated wafer (e.g., at 500°C-1000°C). Most of the hydrogen is introduced into the Mg-doped layers 24 and 26 during this step, resulting in greater than 90% passivation of the Mg dopants.

After the MOCVD process, the wafer is cooled (step 32) in the chamber and, since there is NH₃ gas in the chamber, additional hydrogen is diffused into the Mg-doped layers during the cool-down stage to further passivate the layers to nearly 100%. After the wafer has cooled down to room temperature, the resistivity of the Mg-doped layers is greater than 1x10⁵ ohm-cm, which is effectively insulating. The resulting Mg-doped layers at this stage are classified as i-GaN, where i stands for insulating.

Unintentional H passivation in p-type III-V semiconductors grown by MOCVD is a well-known phenomena. H passivation has been observed in InP, GaAs, AlInGaP, and other materials. See the article "Hydrogen in III-V Device Structures," by Stephen Stockman and Gregory Stillman, Materials Science Forum, volumes 148-149 (1994), pp. 501-536, and the articles referenced therein.

Thermal annealing has been used to activate acceptors in p-type material and is commonly used as part of the device fabrication process in the compound semiconductor industry. This technique has been extended to GaN materials. See U.S. Patent No. 5,252,499 to Neumark Rothschild and U.S. Patent No. 5,306,662 to Nichia Chemical Industries, Ltd. For GaN materials, the thermal annealing process is used to convert insulating material to p-type conductivity.

The process of Fig. 2 reflects the teachings in U.S. Patent No. 5,306,662, assigned to Nichia Chemical Industries, Ltd. The Nichia patent describes embodiments of processes for activating the p-type dopants in GaN layers by annealing the LED structure at temperatures around 700°C or higher for 20 minutes in order to reduce the resistivity of the Mg-doped layers to about 2 ohm-cm. This is shown as step 33 in Fig. 2. The hole density was increased from 8x10¹⁰cm⁻³ (insulating) before annealing to 2x10¹⁷cm⁻³ (conducting) after annealing.

However, as is recognized by those skilled in the art, temperatures greater than 600°C increasingly reduce the intensity of the LED light emission due to the degradation of the crystallinity of the GaN at such temperatures. Accordingly, the Nichia processes for converting the i-GaN layer to a low resistivity p-type layer results in degradation of the LED due to the high temperature anneal used to minimize the resistivity of the Mg-doped GaN layers.

What is needed is a process that does not suffer from the drawbacks of the prior art.

One embodiment of the present invention improves on the conventional process by removing all sources of free hydrogen (typically NH₃) in the epitaxial growth chamber during the post growth cool-down process. The cool-down process will be assumed to take place starting above 700°C and ending at room temperature. By eliminating sources of hydrogen during the cool-down process, any additional passivation of the Mg dopants by hydrogen atoms during cool-down is avoided. In fact, some of the hydrogen in the Mg-doped layers may actually be annealed out during the cool-down stage. In one embodiment, a stable N₂ gas is introduced into the chamber during the cooling process. The Mg-doped GaN layers are measurably p-type when removed from the reactor. In one example, the hole density is greater than 5x10¹⁵cm⁻³. This is significantly higher than the hole density pursuant to the Nichia process after step 32 in Fig. 2, where the hole density is stated to be 8x10¹⁰cm⁻³.

In the next step, the wafer is annealed well below the 700°C anneal temperature described in the Nichia patent to remove nearly all of the hydrogen from the Mg-doped layers. The anneal can take place at a low temperature (e.g., 25-625°C) since the diffusivity of H in the p-type GaN layers is much higher than in i-type GaN layers. Since the "low temperature" anneal does not degrade the GaN crystallinity, the intensity of the LED's emitted light is not decreased by the anneal process.

In other embodiments, the Mg-doped GaN layers are capped with an n-type GaN layer or any other n-type semiconductor layer during epitaxial growth, prior to cool-down. Since hydrogen does not diffuse through n-type semiconductor layers, the n-type cap blocks the in-diffusion of H during the cool-down period and keeps the Mg-doped layers p-type during cooling. The n-type cap is then removed prior to the "low-temperature" anneal step.

In other embodiments, the Mg-doped GaN layers are made slightly p-type after the cool-down, but prior to annealing, by treating the surface of the uppermost Mg-doped layer. This may be done using various processes. Since the Mg-doped GaN layers are p-type, only a "low-temperature" anneal is required to remove the H from the Mg-doped layers, and degradation of the LED is avoided.

In all embodiments, the Mg-doped GaN layer is p-type prior to any post-growth thermal anneal. The processes of the present invention apply to GaN layers doped with any acceptor dopant.

Fig. 1 is a cross-section of one example of an LED having p-type GaN layers formed over n-type GaN layers.

Fig. 2 is a prior art process described in U.S. Patent No. 5,306,662 that converts an insulating, Mg-doped GaN layer to a low resistivity p-type GaN layer using a high-temperature anneal.

Fig. 3 is a flowchart of an embodiment of the present invention for creating low resistivity p-type GaN layers using a low-temperature anneal.

Fig. 4 is an alternative embodiment process for forming p-type GaN layers using a low-temperature anneal step, where an n-type cap is formed over the p-doped layers prior to cooling.

Fig. 5 is an alternative embodiment process for forming p-type GaN layers using a low-temperature anneal step, where the p-doped GaN layers are made p-type prior to annealing by any one of a variety of methods.

Fig. 3 is a flowchart illustrating one embodiment of the invention. In step 30, the various epitaxial layers of an LED are grown, as in step 30 in Fig. 2. Step 30 is conventional, and such growth processes are described in U.S. Patent Nos. 5,729,029; and 6,133,589, incorporated herein by reference. As a brief example of an MOCVD process, organometallic compounds along with other gases are introduced in the chamber while the wafer is heated (typically to around 1000°C). These gases may include trimethyl gallium (TMG), trimethyl aluminum (TMA), and ammonia (NH₃). In this manner, epitaxial films of a III-V group compound are grown on the substrate. The substrate may be any known substrate including sapphire or SiC. By supplying suitable impurity gases during the growth of the films, layers made of the n-doped III-V group and p-doped III-V group compound semiconductors are manufactured. Examples of p-type impurities include Mg, Zn, Cd, C, and Be. Silicon (Si) is a common n-type impurity. There is also a tendency for a MOCVD-grown compound semiconductor to exhibit n-type characteristics even without doping with an n-type impurity.

Since the nitrogen component of GaN is typically obtained from the reaction gas NH₃, there is residual free hydrogen during the epitaxial layer formation process. This hydrogen may form a complex with the p-type dopants (e.g., Mg) in the intended p-type layers, which passivates some of the p-type dopants while the epitaxial layers are growing.

At the end of step 30, the heating of the wafer is stopped and the temperature is ramped down during step 36. During this cool-down stage, any reaction gas incorporating reactive hydrogen is eliminated from the MOCVD chamber (or other chamber depending on the process) by shutting of the source of the reaction gas. In the typical prior art process, NH₃ gas was provided under pressure in the cool-down stage to prevent the GaN material from disassociating during cooling.

In step 36, in addition to removing the NH₃ gas and any other gases that may contribute free hydrogen, N₂ is introduced. Another nitrogen source such as dimethylhydrazine may also be acceptable. Various other stable gases, such as H2, may even be acceptable.

In one embodiment, the cool-down process begins at a temperature above 700°C. While the wafer is cooling down, there is no hydrogen introduction into the p-doped layers. In fact, since the cool-down starts at a relatively high temperature, the grown-in H may be annealed out to some extent, thus lowering the concentration of H in the p-doped layers and increasing the hole density. During the cooling, the lack of any additional hydrogen diffusing into the p-doped layers prevents the p-doped layers from becoming insulating, in contrast to the process of Fig. 2. As a result, the p-doped layers, after the wafer has cooled to room temperature, are measurably p-type, having hole density concentrations greater than 5x10¹⁵cm⁻³, although hole densities greater than 3x10¹⁵cm⁻³ are acceptable to form a p-type layer. A practical upper limit of hole density is about 1x10¹⁸cm⁻³.

Tests by the inventors have shown that an initial hole concentration after step 36 of 5x10¹⁵cm⁻³ corresponds to a resistivity of approximately 5000 ohm-cm. A more preferable hole concentration after step 36 is approximately 3x10¹⁶cm⁻³, which corresponds to a resistivity of 30 ohm-cm. This is in contrast to a resistivity of greater than 10⁵ ohm-cm, characteristic of Mg-doped GaN after step 32 in Fig. 2, as described in Patent No. 5,306,662 to Nichia.

The layers of the LED intended to be p-type are typically doped with Mg (or another p-dopant) to have a dopant concentration on the order of 5x10¹⁹cm⁻³. Even if all hydrogen is ultimately removed from the p-type layers, only about 1% of the p-type dopants are activated since the Mg acceptor activation energy is large (about 200 meV), resulting in a final acceptable hole density on the order of 5x10¹⁷cm⁻³ at room temperature. At this hole density, the p-type layers are of a p+ type and have low resistivity. It is the goal of the process of Fig. 3 to achieve hole densities approaching or exceeding this level.

In step 38 of Fig. 3, a post-growth anneal is performed on the wafer to remove essentially all of the H within the p-type layers. This anneal, in one embodiment is below 625°C. Temperatures as low as 100°C are expected to work, although temperatures in the range of 400-625°C are believed to be best. The anneal is carried out ex-situ (in a separate chamber) or in-situ in either a vacuum or in an atmosphere of N₂. The gas may also be an inert gas such as He, Ar, or a mixture of gases. The resulting hole density is at least as high as that achieved using the prior art process of Fig. 2. However, since the p-type layers formed during the process of Fig. 3 start out p-type prior to the anneal step 38, the anneal step 38 may be carried out at a significantly lower temperature than in Fig. 2. One reason for this is that the diffusivity of H in semiconductors is significantly higher in p-type material than in insulating (i-type) or n-type material. This is because H diffuses as a proton (H⁺) in p-type material instead of a larger neutral species (H°) which may form H₂ in a crystal, or H⁻ which diffuses slowly. The H diffusion is the rate-limiting step in an activation anneal since the H must diffuse to the crystal surface where it will form H₂ or another species and be desorbed into the ambient gas.

Temperatures below 100°C may also be effective in step 38 of Fig. 3, especially if employed in conjunction with a technique for producing election-hole pairs in the acceptor-doped layers, such as election-beam irradiation or illumination with above-bandgap light.

Additionally, since there is less H to be removed during step 38 due to removing sources of H during the cooling stage, the anneal time is further shortened.

The annealing step 38 is conducted for a time necessary to virtually minimize the amount of H within the p-type layers. This results in a maximum achievable hole density and the lowest resistivity of the p-layers. In experiments, this step 38 has been completed within approximately 5 minutes. The time is based on the thickness of the layers, the diffusivity of the layers, and the temperature. The time may even be on the order of a few seconds under optimal conditions.

A lower-temperature activation anneal is advantageous for several reasons. There is less damage to the LED structure, resulting in higher intensity light output. There is also less damage to the surface of the LED, resulting in better electrode contacts (lower forward voltage) and better process yields. Nitrogen loss in the GaN material is minimized by keeping the anneal temperature low. The resulting materials may also have a higher p-type doping as compared to conventional p-layers. It is likely that N vacancies or other donor-like effects are introduced at the high anneal temperatures during the prior art process of Fig. 2, limiting the hole concentration. The higher percentage of activated p-type dopants using the process of Fig. 3 will lower resistivity, improve the LED injection efficiency, lower the on-voltage, reduce heat, and achieve other advantages.

In addition, keeping the material p-type in steps 30 and 36 in Fig. 3 will provide a larger energy barrier to diffusion of H⁺ or any other positively-charged defects from the Mg-doped layers into the undoped or n-type layers.

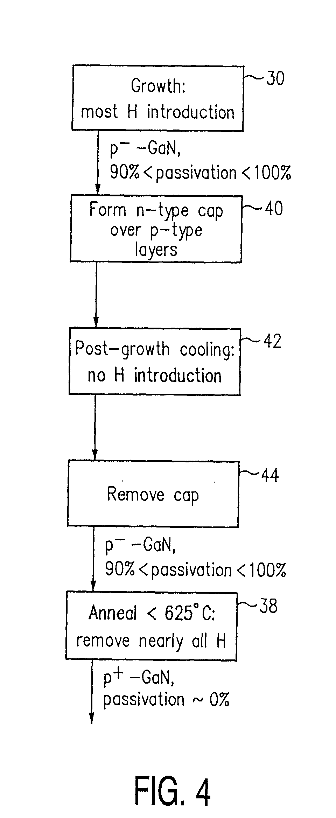

There are several variations of the process that achieve similar low resistivity p-type layers using a low-temperature anneal step. Fig. 4 is a flow chart illustrating a first alternative embodiment wherein the upper p-doped GaN layer is capped (step 40) with an n-type GaN layer or an other n-type semiconductor layer during epitaxial growth, prior to cool-down. Since an n-type layer blocks the diffusion of H, the cap blocks in-diffusion of H during cool-down (step 42). Thus removing NH₃ (or other reaction gases containing H) during the cool-down stage is not necessary. The cap keeps the material p-type during cooling. The n-type cap is then removed (step 44) by a conventional etching step prior to the low temperature anneal step 38. In one embodiment, the anneal step is carried out outside of the MOCVD chamber.

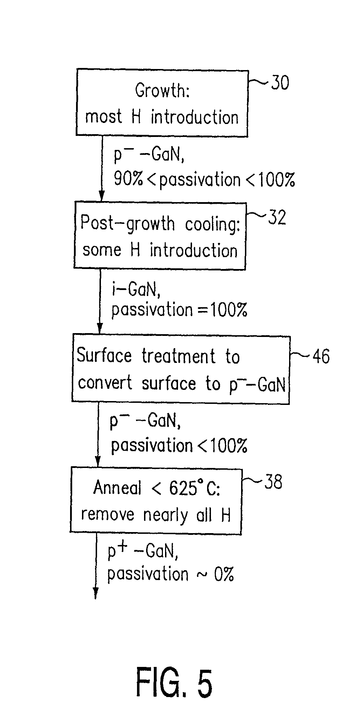

In another embodiment, shown in the flowchart of Fig. 5, steps 30 and 32 are carried out as in the prior art Fig. 2 so that, after cooling, the acceptor-doped layers have insulating characteristics (i-GaN).

In step 46, a chemical etching, plasma etching, or cleaning process is used to treat the surface of the p-doped layers to remove near-surface H or other compensating donors at low temperatures (25-300°C). This includes etching or cleaning in a wet chemical solution that includes a base such as KOH, NaOH, or NH₄OH. This converts the acceptor-doped layers to a medium conductivity p-type at least at the surface. Since the diffusivity of hydrogen is higher in a p-type material as compared to an insulating material, the anneal step 38 may be carried out at a lower temperature and for a shorter period of time as compared to the anneal step 33 in Fig. 2. This results in the advantages previously described with respect to Fig. 3. Other techniques for converting the surface of the acceptor-doped layer to p-type conductivity in step 46 may include ultrasonic cleaning, election-beam irradiation, or exposure to electromagnetic radiation which results in dissociation of the acceptor-hydrogen complex.

For all embodiments, the anneal step for removing hydrogen may also be used to anneal or alloy an ohmic contact to the p-type layer. Such a p-type contact will typically be a metal.

Although these process have been described with respect to various embodiments, it will be understood that these processes are applicable to reducing the resistivity of any acceptor-doped gallium nitride layer (e.g., AlInGaN) in any type of LED, laser diode, or other device utilizing such layers.

While particular embodiments of the present invention have been shown and described, it will obvious to those skilled in the art that changes and modifications may be made without departing from this invention in its broader aspects and, therefore, the appended claims are to encompass within their scope all such changes and modifications as fall within the true spirit and scope of this invention.

## Claims

1. A method for manufacturing a p-type III-V nitride compound semiconductor comprising:
- growing in a chamber a III-V nitride compound semiconductor layer at a first temperature while introducing acceptor impurities into said layer to form an acceptor-doped layer, said chamber containing one or more gases providing hydrogen such that said hydrogen passivates at least some of said acceptor impurities;
- lowering said acceptor-doped layer to a second temperature significantly lower than said first temperature during a cool-down process;
- causing said acceptor-doped layer to be a p-type layer, having p-type conductivity and a hole density between approximately 3x10¹⁵cm⁻³ and 1x10¹⁸cm⁻³, after said cool-down process; and
- annealing said p-type layer at a temperature below 625°C to remove hydrogen from said p-type layer thereby increasing said hole density and lowering the resistivity of said p-type layer.

2. The method of Claim 1 wherein said causing said acceptor-doped layer to be a p-type layer prior to annealing comprises substantially preventing additional hydrogen from diffusing into said acceptor-doped layer during said cooling process.

3. The method of Claim 2 wherein said preventing additional hydrogen from diffusing into said acceptor-doped layer comprises preventing gases containing hydrogen from entering said chamber during said cool-down process and removing hydrogen in said chamber during said cool-down process.

4. The method of Claim 2 wherein said preventing additional hydrogen from diffusing into said acceptor-doped layer comprises forming an n-type semiconductor layer cap over said acceptor-doped layer prior to said cool-down process.

5. The method of Claim 1 wherein said causing said acceptor-doped layer to be a p-type layer prior to said annealing comprises treating a surface of said acceptor-doped layer to increase said hole density at said surface to be greater than 3x10¹⁵cm⁻³.

6. The method of Claim 5 wherein said treating said surface comprises chemically etching said surface.

7. The method of Claim 5 wherein said treating said surface comprises plasma etching said surface.

8. The method of Claim 5 wherein said treating said surface comprises plasma cleaning said surface.

9. The method of Claim 5 wherein said treating said surface comprises chemically cleaning said surface.

10. The method of Claim 9 wherein said chemically cleaning said surface comprises cleaning said surface in a solution of at least one of KOH, NaOH, and NH₄OH.

11. The method of Claim 5 wherein said treating said surface comprises ultrasonically cleaning said surface.

12. The method of Claim 5 wherein said treating said surface comprises irradiating said surface with an electron-beam.

13. The method of Claim 5 wherein said treating said surface comprises exposing said surface to electromagnetic radiation.

14. The method of Claim 1 wherein said growing an acceptor-doped layer results in acceptor impurities in said acceptor-doped layer having greater than 90% passivation prior to said cool-down process.

15. The method of Claim 1 wherein, after said cool-down process, said hole density is greater than 3x10¹⁶cm⁻³.

16. The method of Claim 1 wherein said introducing acceptor impurities comprises doping said semiconductor layer to have a density of acceptor impurities greater than 5x10¹⁸cm⁻³.

17. The method of Claim 1 wherein said annealing is carried out at a temperature in the range of 100-625°C.

18. The method of Claim 1 wherein said annealing is carried out at a temperature below 400°C.

19. The method of Claim 1 wherein said growing in a chamber an acceptor-doped layer is performed in a chamber different from a chamber in which said p-type layer is annealed.

20. The method of Claim 1 wherein said annealing is carried out after said cool-down process prior to any further processing of said p-type layer.

21. The method of Claim 1 wherein said growing in a chamber an acceptor-doped layer further comprises growing a III-V nitride compound n-doped semiconductor layer to form a light emitting diode.

22. The method of Claim 21 wherein said acceptor-doped layer is grown subsequent to said n-doped semiconductor layer.

23. The method of Claim 1 further comprising growing additional one or more III-V nitride compound acceptor-doped layers and causing said additional one or more acceptor-doped layers to be p-type prior to said annealing.

24. The method of Claim 1 wherein said annealing is carried out solely to remove said hydrogen from said p-type layer.

25. The method of Claim 1 wherein said annealing is carried out to remove said hydrogen from said p-type layer as well as to anneal or alloy a p-type ohmic contact.

26. The method of Claim 1 wherein said growing said acceptor-doped layer comprises growing a group III-V compound semiconductor including gallium and nitrogen.

27. The method of Claim 1 wherein said acceptor impurities comprise magnesium.

28. The method of Claim 1 wherein said annealing is carried out in a gas environment containing N₂.

29. The method of Claim 1 wherein the resistivity of said p-type layer prior to said annealing is less than 5000 ohm-cm.

30. The method of Claim 1 wherein the resistivity of said p-type layer prior to said annealing is less than 30 ohm-cm.
